# FASCICULE DE BREVET EUROPEEN

(11) **EP 2 395 360 B1**
(45) Date de publication et mention de la délivrance du brevet: **11.07.2018**
(21) Numéro de dépôt: 11354020.7
(22) Date de dépôt: 10.05.2011
(51) Int. Cl.: G01R 11/16, G01R 22/06

(54) **Dispositif et procédé de comptage d'énergie électrique**
Apparatus and method for metering electrical energy
Vorrichtung und Verfahren zum Messen elektrischer Energie

(30) Priorité: 14.06.2010 FR 1002498
(43) Date de publication de la demande: 14.12.2011
(73) Titulaire: Schneider Electric Industries SAS, 92500 Rueil-Malmaison (FR)
(72) Inventeur: Bruel, Marc, 38050 Grenoble Cedex 09 (FR)
(74) Mandataire: Tripodi, Paul

(56) Documents cités:
- EP-A1- 1 703 289
- GB-A- 2 452 989
- US-A1- 2005 280 559

## Description

### DOMAINE TECHNIQUE

L'invention concerne un dispositif de comptage d'énergie électrique comportant :
- un compteur à impulsions pour fournir une impulsion électrique ou une fermeture de circuit électrique à chaque quantité prédéterminée d'énergie électrique, et
- un module de communication connecté audit compteur à impulsions pour envoyer des informations d'énergie et/ou de puissance électrique, ledit module de communication comportant deux entrées pour recevoir la connexion avec ledit compteur à impulsions.

L'invention concerne aussi un procédé de comptage d'énergie électrique.

### ETAT DE LA TECHNIQUE

Les dispositifs de comptage d'énergie électrique connus comportent un compteur émettant des informations d'énergie électriques en utilisant des impulsions calibrées. Ainsi, chaque impulsion est représentative d'une quantité prédéterminée d'énergie électrique. Les impulsions sont soit des impulsions électriques soit des fermetures de contact électrique. Souvent, les compteurs sont associés à des modules de communication pour émettre à distance des données d'énergie, d'énergie cumulée et/ou de puissance. Un tel dispositif est décrit dans le document GB2452989.

Les modules de communication peuvent aussi émettre des informations supplémentaires notamment des informations d'état fournies par des appareils électriques proches dudit modules. Dans ce cas, le module de communication comporte plusieurs entrées d'état. Cependant, la présence de plusieurs entrées a pour effet d'augmenter la taille du circuit de communication.

### EXPOSE DE L'INVENTION

L'invention a pour but un dispositif et un procédé de comptage d'énergie électrique permettant un nombre d'entrées réduit du circuit de communication.

Dans un dispositif de comptage d'énergie électrique selon l'invention comportant :
- un compteur à impulsions pour fournir une impulsion électrique ou une fermeture de circuit électrique à chaque quantité prédéterminée d'énergie électrique, et
- un module de communication connecté audit compteur à impulsions pour envoyer des informations d'énergie et/ou de puissance électrique, ledit module de communication comportant deux entrées pour recevoir la connexion avec ledit compteur à impulsions, ledit module de communication comporte des moyens de discrimination reliés audites entrées pour différencier des informations d'impulsions d'énergie et des informations d'état d'un appareil électrique connecté audites entrées.

Dans un mode de réalisation préférentiel, ledit compteur à impulsions et un contact d'état dudit appareil électrique sont connectés en parallèle sur lesdites entrées dudit module de communication.

Avantageusement, le module de communication comporte des moyens de calcul d'une puissance moyenne entre deux impulsions.

De préférence, le module de communication comporte des moyens de calcul d'une puissance intermédiaire estimée inférieure à une puissance précédente lorsqu'une durée prédéterminée sans impulsion est dépassée.

De préférence, le module de communication comporte des moyens d'émission de messages de puissance et/ou d'énergie pour émettre des messages à intervalles réguliers ou lorsque la puissance a un écart supérieur à une valeur prédéterminée par rapport à une valeur précédente.

Dans un mode de réalisation particulier, le module de communication comporte des moyens d'émission de messages d'état dudit appareil électrique lorsque les entrées sont actives pendant une durée supérieure à un temps prédéterminé.

Un procédé de comptage d'énergie électrique selon l'invention comporte :
- le contrôle d'entrées d'un module de communication recevant la connexion d'un compteur à impulsion ou à fermeture de contact et la connexion d'un contact d'état d'un appareil électrique,
- La détection d'impulsions fournies par ledit compteur à impulsions, chaque impulsion étant représentative d'une quantité prédéterminée d'énergie électrique,
- l'émission par le module de communication d'informations d'énergie et/ou de puissance électrique, et
- la discrimination pour différencier des informations d'impulsions d'énergie et des informations d'état d'un appareil électrique connecté audites entrées du module de communication.

Avantageusement, le procédé comporte le calcul d'une puissance moyenne entre deux impulsions.

De préférence, le procédé comporte le calcul d'une puissance intermédiaire estimée inférieure à une puissance précédente lorsqu'une durée prédéterminée sans impulsion est dépassée.

De préférence, le procédé comporte l'émission de messages de puissance et/ou d'énergie pour émettre lesdits messages à intervalles réguliers ou lorsque la puissance a un écart supérieur à une valeur prédéterminée par rapport à une valeur précédente.

Dans un mode de réalisation préférentiel, le procédé comporte l'émission de messages d'état dudit appareil électrique lorsque lesdites entrées sont actives pendant une durée supérieure à un temps prédéterminé.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma d'une installation avec un dispositif de mesure d'énergie électrique selon un premier mode de réalisation de l'invention ;
- la figure 2 montre des signaux d'impulsion fournis par un compteur d'énergie électrique à un circuit de communication dans un dispositif selon un mode de réalisation de l'invention ;
- la figure 3 représente un schéma avec un circuit de communication, un compteur d'énergie électrique, et un appareil électrique dans un dispositif selon un mode de réalisation de l'invention ;
- les figures 4A, 4B et 4C montrent des signaux représentatifs de traitements dans un dispositif et un procédé selon un mode de réalisation de l'invention ; et
- la figure 5 représente un organigramme d'un procédé de comptage d'énergie électrique selon un mode de réalisation de l'invention.

### DESCRIPTION DETAILLEE DE MODES DE REALISATION PREFERES

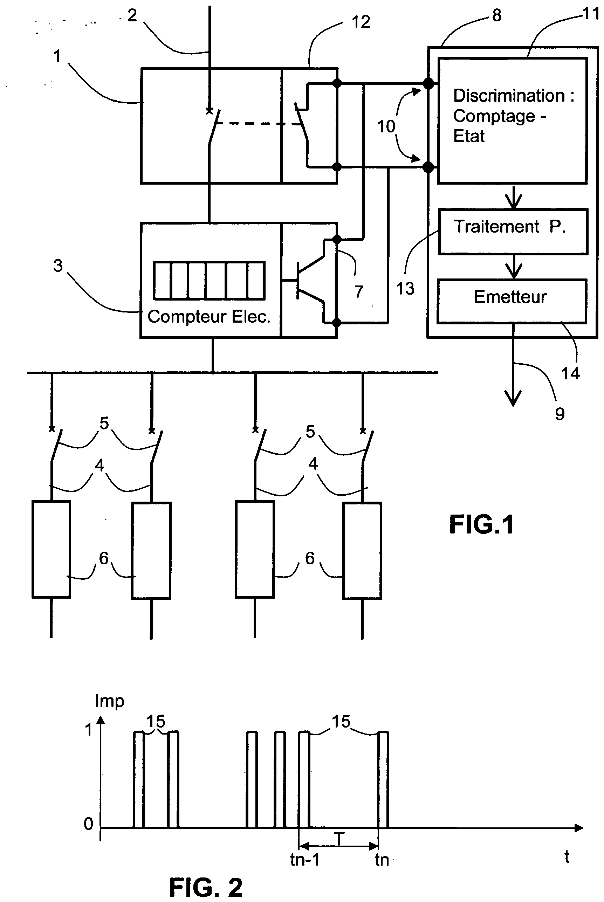

Le schéma d'une installation avec un dispositif de mesure d'énergie électrique est représenté sur la figure 1. Un appareil électrique 1 tel un disjoncteur de tête est connecté en série avec une ligne principale 2 d'alimentation électrique. Un compteur électrique 3 est connecté aussi en série avec la ligne principale 2 et l'appareil électrique 1. Ainsi, le comptage de l'énergie électrique est dépendant d'un courant électrique circulant dans la ligne 2. En aval du compteur et du disjoncteur, la ligne principale alimente plusieurs départs divisionnaires 4 protégés par des disjoncteurs 5 et alimentant des charges 6.

Le dispositif de comptage d'énergie électrique comporte le compteur 3 du type à impulsions pour fournir une impulsion électrique ou une fermeture de circuit électrique à chaque quantité prédéterminée d'énergie électrique. Une sortie 7 du compteur est représentée par une sortie à transistor ouvert fermant le circuit à chaque impulsion. Le dispositif de comptage comporte aussi un module 8 de communication connecté audit compteur à impulsions pour envoyer des informations 9 d'énergie et de puissance électrique, ledit module comportant deux entrées 10 pour recevoir la connexion avec ledit compteur 3 à impulsions. Selon un mode de réalisation de l'invention, le module de communication 8 comporte un module 11 de discrimination relié audites entrées 10 pour différencier des informations d'impulsions d'énergie et des informations d'état d'un appareil électrique 1 connecté aussi audites entrées. L'état de l'appareil électrique est fourni à travers un contact auxiliaire d'état 12 associé à son mécanisme. Ledit contact auxiliaire a une ou plusieurs positions en fonction des états ouvert, fermé ou déclenché dans le cas d'un disjoncteur.

Le compteur à impulsions 3 et un contact d'état 12 de l'appareil électrique sont connectés en parallèle sur les entrées 10 du module de communication. Le module de discrimination détecte une information d'état lorsque les entrées sont activées pendant une durée prédéterminée supérieure à une durée maximale d'impulsion. Par exemple, si des impulsions durent 20 ms (millisecondes) la durée prédéterminée de test de l'état peut être de 300 ms. Ainsi, le module de communication émet des messages d'état dudit appareil électrique lorsque les entrées sont actives pendant une durée supérieure à un temps prédéterminé.

Le module de communication comporte aussi un module 13 de traitement pour le calcul d'énergie cumulée et de puissance notamment, ainsi qu'un émetteur 14 pour émettre des informations.

La figure 2 montre des signaux d'impulsion 15 fournis par un compteur d'énergie électrique à un circuit de communication. L'état 1 des impulsions correspond à un état actif et à la fermeture de la sortie 7 du compteur. A chaque impulsion, une valeur Et cumulée de l'énergie est incrémentée d'une valeur prédéterminée En et la puissance peut être calculée en fonction du temps T écoulé entre deux débuts d'impulsions, soit P=En/T.

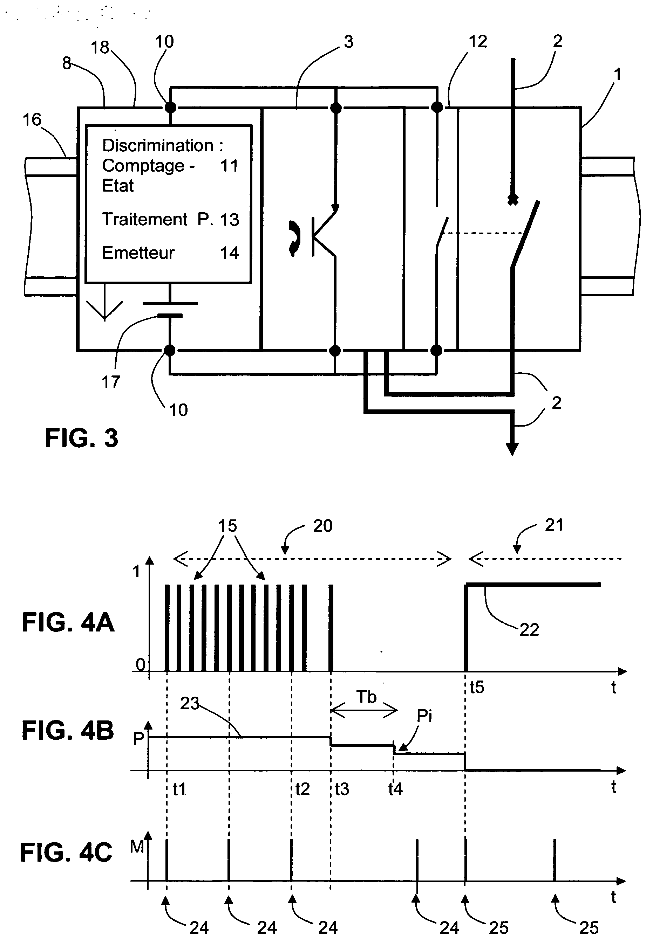

La figure 3 représente un schéma avec un circuit de communication 8, un compteur 3 d'énergie électrique, et un appareil électrique 1 avec son contact auxiliaire 12 d'état dans un dispositif selon un mode de réalisation de l'invention. Ces éléments peuvent être des appareils modulaires disposés sur un support 16 en forme de rail. Les sorties du compteur 3 et du contact auxiliaire 12 sont connectées en parallèle sur les entrées 10 du module 8 de communication. Sur ce schéma, le module de communication 8 comporte une batterie ou une pile 17 et un circuit 18 de traitement global de la communication comportant les fonctions du module 11 de discrimination, du module 13 de traitement pour le calcul d'énergie cumulée et de puissance, et de émetteur 14. Le circuit 18 et la pile sont connectés entre les entrées 10 du module 8.

Les figures 4A, 4B et 4C montrent des valeurs de traitement dans un dispositif et un procédé selon un mode de réalisation de l'invention. La figure 4A montre l'état des entrées 10 du module de communication 8. Sur une première période 20, les entrées reçoivent des impulsions 15 de comptage d'énergie électrique alors que sur une seconde période 21 à partir d'un instant ts un signal d'état 22 apparait en continu. La figure 4B montre une courbe 23 représentative de la détermination d'une valeur de puissance moyenne telle que P=En/T, T étant la période entre deux impulsions consécutives. Lorsque les impulsions sont régulières, la puissance moyenne est constante, par exemple entre des instants t1 et t2. Si les impulsions sont plus distantes, la puissance P diminue comme à l'instant t3. Dans le cas où les intervalles de temps entre deux impulsions deviennent trop longs ou s'arrêtent, le module de communication calcule une valeur de puissance Pi intermédiaire estimée inférieure à une puissance précédente lorsqu'une durée prédéterminée sans impulsion est dépassée. Par exemple à l'instant t4, une durée Tb sans impulsion est dépassée et la valeur de la puissance P est réduite. La figure 4C montre des envois 24 de messages effectués par le module de communication 8. Ainsi, les envois de messages comportant des valeurs de puissance et/ou d'énergie sont émis de préférence à intervalles réguliers ou lorsque la puissance a un écart supérieur à une valeur prédéterminée par rapport à une valeur précédente. Des envois de messages 25 peuvent aussi être déclenchés lorsqu'un événement particulier survient, notamment par la détection de la fermeture d'un contact d'état sur les entrées 10.

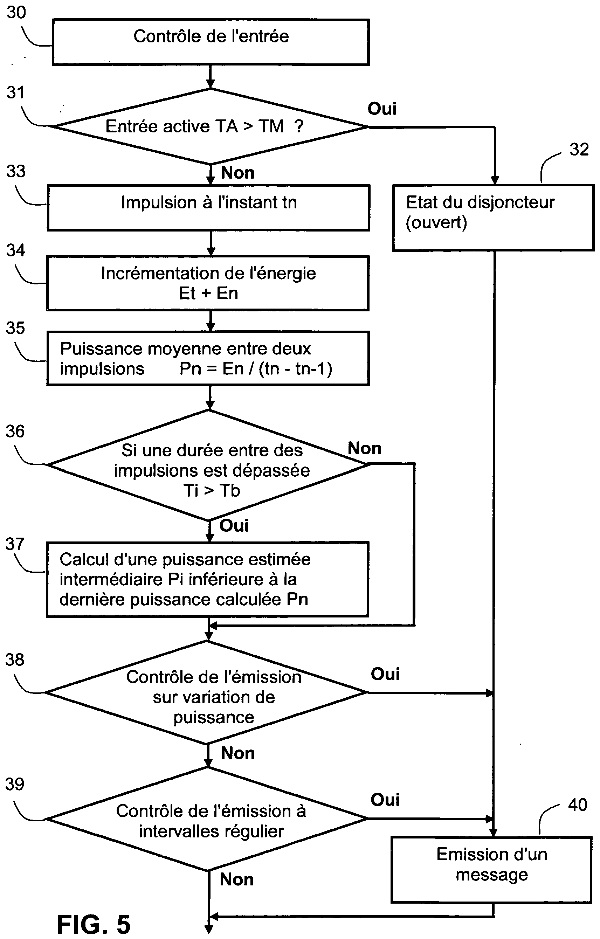

La figure 5 représente un organigramme d'un procédé de comptage d'énergie électrique selon un mode de réalisation de l'invention. Le procédé comporte une première étape 30 de contrôle d'entrées 10 d'un module de communication 8 recevant la connexion d'un compteur 3 à impulsion à fermeture de contact et la connexion d'un contact 12 d'état d'un appareil électrique 1. Une étape 31 effectue une discrimination pour différencier des informations d'impulsions d'énergie et des informations d'état d'un appareil électrique connecté audites entrées du module de communication. Si les entrées 10 sont actives pendant une durée TA supérieure à une durée maximale TM, alors un état dudit contact est détecté à l'étape 32. Dans le cas d'impulsions, la durée TA est très inférieure à TM. A une étape 33, il y a une détection d'impulsions fournies par un compteur à impulsions, chaque impulsion étant représentative d'une quantité prédéterminée d'énergie électrique. Une étape 34 permet de calculer une énergie Et cumulée en incrémentant une valeur précédente par une valeur prédéterminée En à chaque impulsion.

Un calcul d'une puissance moyenne Pn entre deux impulsions est réalisé à une étape 35. Dans ce cas, la puissance Pn est dépendante de la durée entre deux impulsions. Par exemple, si une impulsion arrive à un instant tn et une impulsion précédente était arrivée à un instant tn-1, la valeur de la puissance moyenne entre deux impulsions est Pn=En/(tn-tn-1) où En est la valeur d'énergie attribuée à chaque impulsion.

Une étape 36 contrôle si une durée sans impulsion dépasse une durée de contrôle maximale Tb afin de ne pas garder une valeur élevée de puissance alors que la puissance diminue suite à un espacement des impulsions. Ainsi, si la durée Tb est dépassée, une étape 37 calcule une puissance intermédiaire Pi estimée inférieure à une puissance précédente Pn.

Une étape 38 contrôle l'émission de messages de puissance et/ou d'énergie pour émettre des messages lorsque la puissance a un écart supérieur à une valeur prédéterminée par rapport à une valeur précédente. Une étape 39 contrôle l'émission de messages de puissance et/ou d'énergie pour émettre des messages à intervalles réguliers dépendant du temps et/ou d'un nombre prédéterminés d'impulsions.

Une étape 40 permet l'émission de messages d'informations d'énergie et de puissance électrique, notamment dans les conditions définies par le contrôle des étapes 38 ou 39. Dans l'organigramme de la figure 5, l'étape 40 permet aussi l'émission de messages d'état dudit appareil électrique lorsque lesdites entrées sont actives pendant une durée supérieure à un temps prédéterminé. Dans ce cas, l'étape 40 est aussi activée par l'étape 32.

Dans les modes de réalisation décrits ci-dessus, l'appareil électrique est notamment un disjoncteur avec un contact auxiliaire. Cependant, l'invention s'applique aussi à des ensembles ou tout type d'appareil comportant un contact d'état pouvant être associé à un compteur à impulsions.

## Revendications

1. Dispositif de comptage d'énergie électrique comportant :
- un compteur (3) à impulsions pour fournir une impulsion (15) électrique ou une fermeture de circuit électrique à chaque quantité prédéterminée d'énergie électrique, et
- un module (8) de communication connecté audit compteur (3) à impulsions pour envoyer des informations d'énergie et/ou de puissance électrique, ledit module (8) de communication comportant deux entrées (10) pour recevoir la connexion avec ledit compteur à impulsions,
**caractérisé en ce que** ledit module (8) de communication comporte des moyens (11, 18, 31) de discrimination reliés audites entrées (10) pour différencier des informations d'impulsions d'énergie et des informations d'état d'un appareil électrique (1) connecté audites entrées (10).

2. Dispositif selon la revendication 1 **caractérisé en ce que** ledit compteur (3) à impulsions et un contact (12) d'état dudit appareil électrique (1) sont connectés en parallèle sur lesdites entrées (10) dudit module (8) de communication.

3. Dispositif selon l'une des revendications 1 ou 2 **caractérisé en ce que** le module (8) de communication comporte des moyens (13, 35) de calcul d'une puissance (Pn, 23) moyenne entre deux impulsions (15).

4. Dispositif selon l'une quelconque des revendications 1 à 3 **caractérisé en ce que** le module de communication comporte des moyens (13, 18, 37) de calcul d'une puissance intermédiaire (Pi, 23) estimée inférieure à une puissance précédente lorsqu'une durée (Tb) prédéterminée sans impulsion est dépassée.

5. Dispositif selon l'une quelconque des revendications 1 à 4 **caractérisé en ce que** le module (8) de communication comporte des moyens d'émission (14, 18, 40) de messages de puissance et/ou d'énergie pour émettre des messages à intervalles réguliers ou lorsque la puissance a un écart supérieur à une valeur prédéterminée par rapport à une valeur précédente.

6. Dispositif selon l'une quelconque des revendications 1 à 5 **caractérisé en ce que** le module (8) de communication comporte des moyens d'émission (14, 18, 40) de messages d'état dudit appareil électrique (1) lorsque les entrées (10) sont actives pendant une durée (TA) supérieure à un temps prédéterminé (TM).

7. Procédé de comptage d'énergie électrique **caractérisé en ce qu'**il comporte :
- le contrôle (30) d'entrées d'un module de communication recevant la connexion d'un compteur (3) à impulsion ou à fermeture de contact et la connexion d'un contact (12) d'état d'un appareil (1) électrique,
- La détection (33) d'impulsions fournies par ledit compteur (3) à impulsions, chaque impulsion (15) étant représentative d'une quantité prédéterminée (En) d'énergie électrique,
- l'émission (24, 40) par le module de communication d'informations d'énergie et/ou de puissance électrique, et
- la discrimination (11, 31) pour différencier des informations d'impulsions (15, 20) d'énergie et des informations (21, 22) d'état d'un appareil électrique connecté audites entrées (10) du module (8) de communication.

8. Procédé selon la revendication 7 **caractérisé en ce qu'**il comporte le calcul (35) d'une puissance moyenne entre deux impulsions (15).

9. Procédé selon l'une des revendications 7 ou 8 **caractérisé en ce qu'**il comporte le calcul (Pi) d'une puissance intermédiaire estimée inférieure à une puissance précédente (Pn) lorsqu'une durée prédéterminée sans impulsion est dépassée.

10. Procédé selon l'une quelconque des revendications 7 à 9 **caractérisé en ce qu'**il comporte l'émission (38, 39, 40) de messages de puissance et/ou d'énergie pour émettre lesdits messages à intervalles réguliers ou lorsque la puissance a un écart supérieur à une valeur prédéterminée par rapport à une valeur précédente.

11. Procédé selon l'une quelconque des revendications 7 à 10 **caractérisé en ce qu'**il comporte l'émission (32, 40) de messages d'état dudit appareil électrique lorsque lesdites entrées (10) sont actives pendant une durée (TA) supérieure à un temps prédéterminé (TM).

## Patentansprüche

1. Vorrichtung zum Messen elektrischer Energie, umfassend:
- einen Impulszähler (3), um einen elektrischen Impuls (15) oder ein Schließen einer elektrischen Schaltung bei jeder vorbestimmten Menge an elektrischer Energie zu liefern, und
- ein Kommunikationsmodul (8), das an den Impulszähler (3) angeschlossen ist, um Informationen zu Energie und/oder elektrischer Leistung zu senden, wobei das Kommunikationsmodul (8) zwei Eingänge (10) umfasst, um den Anschluss an den Impulszähler aufzunehmen,
**dadurch gekennzeichnet, dass** das Kommunikationsmodul (8) Unterscheidungsmittel (11, 18, 31) umfasst, die an die Eingänge (10) angeschlossen sind, um Informationen zu Energieimpulsen und Informationen zum Zustand eines elektrischen Geräts (1), das an die Eingänge (10) angeschlossen ist, zu unterscheiden.

2. Vorrichtung nach Anspruch 1, **dadurch gekennzeichnet, dass** der Impulszähler (3) und Kontakt (12) eines Zustands des elektrischen Geräts (1) parallel an den Eingängen (10) des Kommunikationsmoduls (8) angeschlossen sind.

3. Vorrichtung nach einem der Ansprüche 1 oder 2, **dadurch gekennzeichnet, dass** das Kommunikationsmodul (8) Mittel (13, 35) zur Berechnung einer durchschnittlichen Leistung (Pn, 23) zwischen zwei Impulsen (15) umfasst.

4. Vorrichtung nach einem der Ansprüche 1 bis 3, **dadurch gekennzeichnet, dass** das Kommunikationsmodul Mittel (13, 18, 37) zur Berechnung einer Zwischenleistung (Pi, 23), die als geringer als eine vorhergehende Leistung eingeschätzt wird, wenn eine vorbestimmte Dauer (Tb) ohne Impuls überschritten wird, umfasst.

5. Vorrichtung nach einem der Ansprüche 1 bis 4, **dadurch gekennzeichnet, dass** das Kommunikationsmodul (8) Sendemittel (14, 18, 40) von Nachrichten zu Leistung und/oder Energie umfasst, um in regelmäßigen Abständen oder, wenn die Leistung eine größere Abweichung als ein vorbestimmter Wert zu einem vorhergehenden Wert aufweist, Nachrichten zu senden.

6. Vorrichtung nach einem der Ansprüche 1 bis 5, **dadurch gekennzeichnet, dass** das Kommunikationsmodul (8) Sendemittel (14, 18, 40) von Nachrichten zum Zustand des elektrischen Geräts (1), wenn die Eingänge (10) während einer längeren Dauer (TA) als eine vorbestimmte Dauer (TM) aktiv sind, umfasst.

7. Verfahren zum Messen elektrischer Energie, **dadurch gekennzeichnet, dass** es umfasst:
- die Kontrolle (30) von Eingängen eines Kommunikationsmoduls, das den Anschluss eines Zählers (3) mit Impuls oder Schließen eines Kontakts und den Anschluss eines Kontakts (12) zum Zustand eines elektrischen Geräts (1) aufnimmt,
- die Erfassung (33) von Impulsen, die von dem Impulszähler (3) geliefert werden, wobei jeder Impuls (15) für eine vorbestimmte Menge (En) elektrischer Energie repräsentativ ist,
- das Senden (24, 40) von Informationen zu Energie und/oder elektrischer Leistung durch das Kommunikationsmodul, und
- die Unterscheidung (11, 31) von Impulsinformationen (15, 20) zur Energie und Informationen (21, 22) zum Zustand eines elektrischen Geräts, das an die Eingänge (10) des Kommunikationsmoduls (8) angeschlossen ist.

8. Verfahren nach Anspruch 7, **dadurch gekennzeichnet, dass** es die Berechnung (35) einer durchschnittlichen Leistung zwischen zwei Impulsen (15) umfasst.

9. Verfahren nach einem der Ansprüche 7 oder 8, **dadurch gekennzeichnet, dass** es die Berechnung (Pi) einer Zwischenleistung, die als geringer als eine vorhergehende Leistung (Pn) eingeschätzt wird, wenn eine vorbestimmte Dauer ohne Impuls überschritten wird, umfasst.

10. Verfahren nach einem der Ansprüche 7 bis 9, **dadurch gekennzeichnet, dass** es das Senden (38, 39, 40) von Nachrichten zur Leistung und/oder Energie umfassen, um in regelmäßigen Abständen oder, wenn die Leistung eine größere Abweichung als ein vorbestimmter Wert zu einem vorhergehenden Wert aufweist, Nachrichten zu senden.

11. Verfahren nach einem der Ansprüche 7 bis 10, **dadurch gekennzeichnet, dass** es das Senden (32, 40) von Nachrichten zum Zustand des elektrischen Geräts, wenn die Eingänge (10) während einer längeren Dauer (TA) als eine vorbestimmte Dauer (TM) aktiv sind, umfasst.

## Claims

1. Device for metering electrical energy having:
- a pulse-type meter (3) in order to provide an electrical pulse (15) or completion of an electrical circuit for each predetermined quantity of electrical energy, and
- a communication module (8) connected to said pulse-type meter (3) in order to send energy and/or electric power information, said communication module (8) having two inputs (10) in order to receive the connection to said pulse-type meter,
**characterized in that** said communication module (8) has discrimination means (11, 18, 31) connected to said inputs (10) in order to distinguish between energy pulse information and state information of an electrical appliance (1) connected to said inputs (10).

2. Device according to Claim 1, **characterized in that** said pulse-type meter (3) and a state contact (12) of said electrical appliance (1) are connected in parallel to said inputs (10) of said communication module (8).

3. Device according to either of Claims 1 and 2, **characterized in that** the communication module (8) has means (13, 35) for calculating an average power (Pn, 23) between two pulses (15).

4. Device according to any one of Claims 1 to 3, **characterized in that** the communication module has means (13, 18, 37) for calculating an estimated intermediate power (Pi, 23) lower than a previous power when a predetermined period (Tb) without a pulse is passed.

5. Device according to any one of Claims 1 to 4, **characterized in that** the communication module (8) has means (14, 18, 40) for transmitting power and/or energy messages in order to transmit messages at regular intervals or when the power differs from a previous value by more than a predetermined value.

6. Device according to any one of Claims 1 to 5, **characterized in that** the communication module (8) has means (14, 18, 40) for transmitting state messages of said electrical appliance (1) when the inputs (10) are active for a period (TA) longer than a predetermined time (TM).

7. Method for metering electrical energy, **characterized in that** it involves:
- checking (30) inputs of a communication module receiving the connection of a pulse-type or contact-closure meter (3) and the connection of a state connection (12) of an electrical appliance (1),
- detecting (33) pulses provided by said pulse-type meter (3), each pulse (15) being representative of a predetermined quantity (En) of electrical energy,
- the communication module transmitting (24, 40) energy and/or electric power information, and
- discriminating (11, 31) in order to distinguish between energy pulse information (15, 20) and state information (21, 22) of an electrical appliance connected to said inputs (10) of the communication module (8).

8. Method according to Claim 7, **characterized in that** it involves calculating (35) an average power between two pulses (15).

9. Method according to either of Claims 7 and 8, **characterized in that** it involves calculating (Pi) an estimated intermediate power lower than a previous power (Pn) when a predetermined period without a pulse is passed.

10. Method according to any one of Claims 7 to 9, **characterized in that** it involves transmitting (38, 39, 40) power and/or energy messages in order to transmit said messages at regular intervals or when the power differs from a previous value by more than a predetermined value.

11. Method according to any one of Claims 7 to 10, **characterized in that** it involves transmitting (32, 40) state messages of said electrical appliance when said inputs (10) are active for a period (TA) longer than a predetermined time (TM).
